# EUROPÄISCHE PATENTANMELDUNG

(11) **EP 0 524 430 A1**
(43) Veröffentlichungstag der Anmeldung: **27.01.1993**
(21) Anmeldenummer: 92110345.3
(22) Anmeldetag: 19.06.1992
(51) Int. Cl.: H05K 7/12

(54) **Einrichtung zum Befestigen eines LC-Displays auf einer Leiterplatte**

(30) Priorität: 25.07.1991 DE 9109166 U
(71) Anmelder: GRUNDIG E.M.V. Elektro-Mechanische Versuchsanstalt Max Grundig holländ. Stiftung & Co. KG., D-90762 Fürth (DE)
(72) Erfinder: Henning, Johannes F., Dipl.-Ing., Grundig E.M.V., W-8510 Fürth/Bay. (DE)
(74) Vertreter: Eichstädt, Alfred

(57) **Zusammenfassung**

Die Kontaktierung eines LC-Displays (4) mit einer Leiterplatte (3) erfolgt in der Regel über Kontaktgummistreifen (11). Damit der notwendige Kontaktdruck zwischen den Leiterbahnen (18, 19) und dem Kontaktgummi (11) zustande kommt, wird das LC-Display (4) von einem Gehäuse (2) umfaßt und unter Deformation des Leitgummis (11) gegen die Leiterplatte (3) gepreßt. Das Gehäuse wird mit der Leiterplatte (3) fest verbunden, damit dieser Druck bestehen bleibt.

Es wird eine besondere Art von Befestigung des Gehäuses (2) mit der Leiterplatte (3) vorgeschlagen. Anders als bei bisher bekannten Methoden, wie Anschrauben, Verschränkung von durch die Leiterplatte ragenden Lappen des Gehäuses (2) oder Verhaken von durch die Leiterplatte ragenden Lappen mit Widerhaken (14), werden hier besonders geformte Befestigungselemente (14') vorgeschlagen, die sich beim Durchstecken durch die Leiterplatte (3) selbständig verdrehen und anschließend durch Rückfedern einen festen Verschluß des Gehäuses (2) mit der Leiterplatte (3) bewirken. Die Ausführung der vorgeschlagenen Befestigungselemente (14') benötigt unterhalb der Leiterplatte (3) nur wenig Raum.

## Beschreibung

Die Erfindung bezieht sich auf eine Einrichtung zum Befestigen eines LC-Displays auf einer Leiterplatte gemäß dem Oberbegriff des Anspruchs 1.

LC-Displays werden in zunehmendem Maß als Ausgabebausteine in Geräten der Unterhaltungselektronik, in Küchengeräten, Waschmaschinen, Automaten etc. eingesetzt. Sie bestehen in der Regel aus dem eigentlichen LC-Display, welches, meist über Leitgummi, mit einer zugehörigen Leiterplatte kontaktiert wird. Die Kontaktverbindung zwischen dem LC-Display und der Leiterplatte muß dazu unter Druck stehen, damit über den Leitgummi eine sichere elektrische Verbindung zustandekommt. Zu diesem Zweck wird in vielen Fällen das LC-Display mit den Leitgummi-Streifen mit einem Gehäuse umgeben, welches gegen den Druck der Leitgummi-Streifen in der darunter liegenden Leiterplatte befestigt wird.

Es ist bekannt, derartige Gehäuse anzuschrauben, was eine material- und zeitaufwendige Lösung darstellt.

Ebenfalls bekannt sind Lösungen, bei denen vom Gehäuse vorstehende Lappen durch Schlitze in die Leiterplatte gesteckt und unterhalb der Leiterplatte verschränkt werden. Auch diese Möglichkeit ist kostenintensiv.

Des weiteren kennt man Lösungen, bei denen vom Gehäuse vorstehende Lappen mit Widerhaken versehen sind, die nach dem Durchstecken der Lappen durch die Leiterplatte, sich an der dem Gehäuse gegenüberliegenden Seite der Leiterplatte verhaken. Eine derartige Lösung ist zwar wirtschaftlich, benötigt aber unterhalb der Leiterplatte viel Raum, da die Lappen, konstruktionsbedingt, relativ weit von der Leiterplatte herausragen müssen. Dieser Raum ist aber, zumindest bei kleinen Geräten wie Handsprechgeräte, Hand-Telefonapparate und dergleichen, meist nicht vorhanden.

Aufgabe der Erfindung ist es daher, eine Befestigungseinrichtung für ein LC-Display zu schaffen, die eine Montage eines zum LC-Display-Baustein gehörenden Gehäuses auf einer Leiterplatte ohne Werkzeug ermöglicht, wobei unterhalb der Leiterplatte nur ein geringer Raum benötigt werden soll.

Diese Aufgabe wird erfindungsgemäß durch die Merkmale im kennzeichnenden Teil des Schutzanspruchs 1 gelöst.

Die Unteransprüche zeigen vorteilhafte Ausgestaltungen der Erfindung auf.

Im Anspruch 2 ist eine vereinfachte Ausführungsform eines Befestigungselements beschrieben.

Im Anspruch 3 ist die Möglichkeit aufgezeigt, außer an den Längs- auch an den Querseiten des Gehäuses Befestigungselemente anzubringen.

Anspruch 4 erläutert den nur minimal benötigten Raum der aus der Leiterplatte herausragenden Befestigungselemente.

Anspruch 5 zeigt eine Maßnahme auf, womit die Verrastung der Befestigungselemente unter der Leiterplatte sicher erfolgt.

Anspruch 6 beschreibt die Form der mit den Befestigungselementen des Gehäuses korrespondierenden Öffnungen in der Leiterplatte, um eine Montage des Gehäuses ohne Werkzeug zu ermöglichen.

Nachstehend wird die Erfindung anhand der Zeichnungen näher erläutert. Es zeigen:
- Fig. 1: Die erfindungsgemäße Einrichtung in perspektivischer Darstellung,
- Fig. 2: eine Schnittansicht der Fig. 1 entlang der Linie Y-Y,
- Fig. 3: ein erfindungsgemäßes Befestigungselement in drei Ansichten,
- Fig. 4: ein erfindungsgemäßes Befestigungselement samt der erfindungsgemäßen Öffnung in der Leiterplatte und
- Fig. 5: Befestigungselement und Öffnung in der Leiterplatte in montiertem Zustand des Verbindungselements.

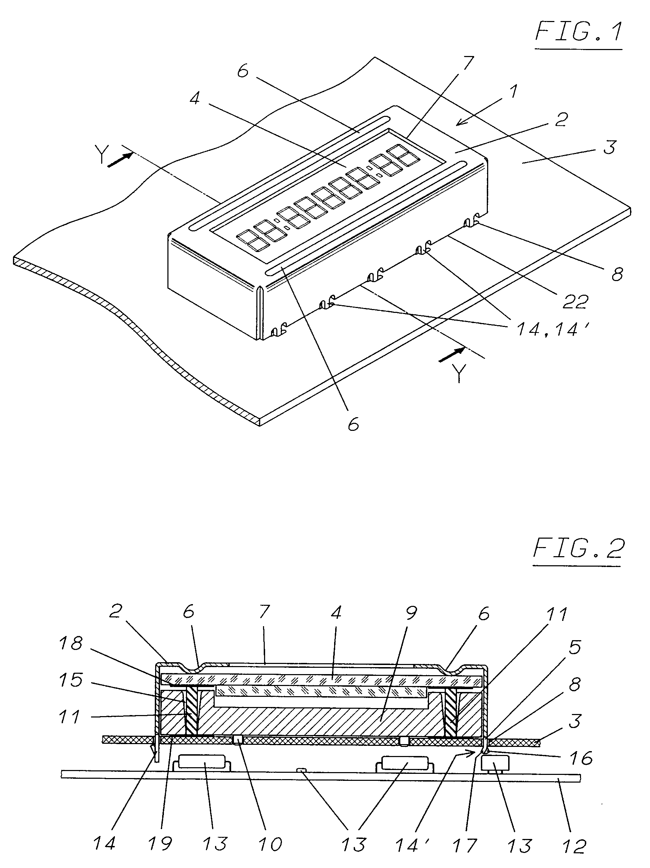

Die Fig. 1 zeigt in perspektivischer Darstellung die erfindungsgemäße Einrichtung von außen. Auf einer Leiterplatte 3 ist das Gehäuse 2 mit an den Längsseiten des Gehäuses befindlichen Befestigungselementen 14, 14' befestigt. Die beiden Versteifungssicken 6 dienen zum einen zur Stabilisierung des Gehäuses 2 und zum anderen zum definierten Druck des Gehäuses 2 auf das darunter liegende LC-Display 4. Durch das Fenster 7 ist der Blick auf das LC-Display 4 frei.

In der Fig. 2 ist der innere Aufbau der Einrichtung zu sehen. Die Darstellung zeigt einen Schnitt entlang der Linie Y-Y aus Fig. 1. Hier erkennt man das LC-Display 4, dessen Kontakte 18 über Leitgummistreifen 11 mit den Leiterplatten-Kontakten 19 elektrisch leitend verbunden sind. Als Führung für die Leitgummistreifen zur Erzielung einer genauen Zuordnung zu den entsprechenden Kontakten dient ein Rahmen 9, welcher wiederum über Zapfen 10 der Leiterplatte 3 zugeordnet ist. Über dem genannten Aufbau ist das Gehäuse 2 zu erkennen, welches über die Versteifungssicken 6 auf das LC-Display 4 drückt. Die Befestigung des Gehäuses ist auf zwei Arten dargestellt. Links ist ein Befestigungselement 14 nach dem Stand der Technik zu sehen, rechts ein erfindungsgemäßes Befestigungselement 14'. Es ist deutlich die Differenz der unter der Leiterplatte 3 herausragenden Teile der Befestigungselemente zu erkennen. In der gewählten Ausführungsform befindet sich unter dem LC-Display-Baustein eine weitere Leiterplatte 12, die mit diversen Bauteilen 13 bestückt ist. Durch die erfindungsgemäße Befestigungsart können sich auch unterhalb des Befestigungselements Bauteile 13 befinden.

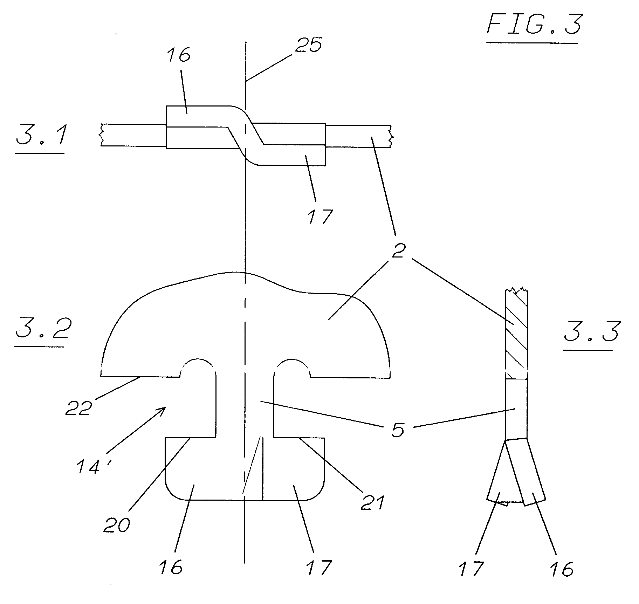

In der Fig. 3 ist ein Befestigungselement 14' gemäß der Erfindung vergrößert dargestellt. Unterhalb des Federbereichs 5 schließen die beiden Flügel 16 und 17 an, die so gestaltet sind, daß ihre Flächen nach unten schräg verlaufen und zwar im gleichen Drehsinn um eine Achse 25, die mittig durch den Federbereich 5 geht. Nach erfolgter Montage drücken die beiden Rastkanten 20, 21 auf die Unterseite der Leiterplatte 3 und sichern so die Verbindung zwischen Gehäuse 2 und Leiterplatte 3.

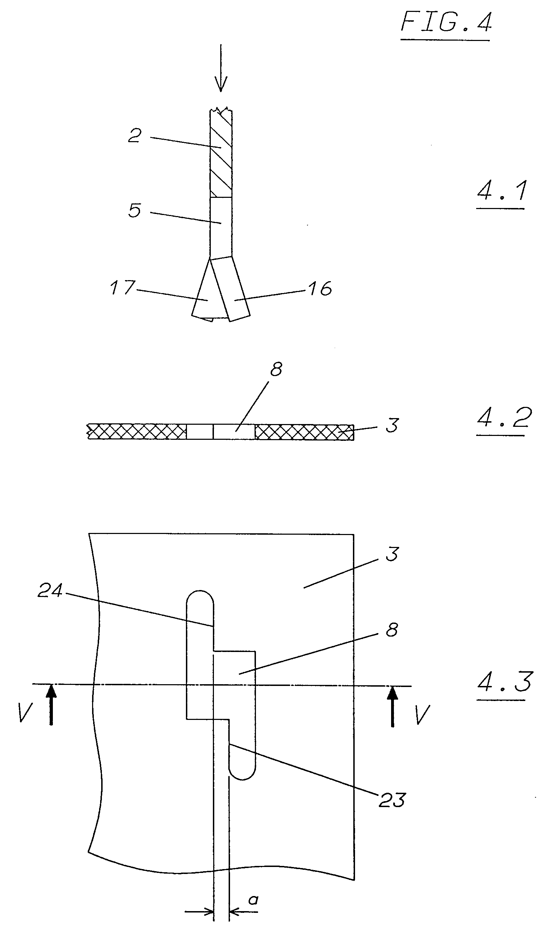

Die Fig. 4 zeigt die Zuordnung eines Befestigungselements 14 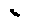 zu einer Öffnung 8 in der Leiterplatte 3. Fig. 4.2 ist dabei eine Schnittdarstellung entlang der Linie V-V von Fig. 4.3. Wird das Befestigungselement in Pfeilrichtung auf die Öffnung 8 bewegt, so treffen die beiden Flügel 16 und 17 auf die Konturkanten 23 und 24 der Öffnung 8 auf, gleiten daran entlang und verwinden den Federbereich 5 des Befestigungselements, bis die beiden Rastkanten 20, 21 die Leiterplattenunterseite erreicht haben, um dann durch das sich wieder entspannende Federteil 5 wieder zurückzufedern.

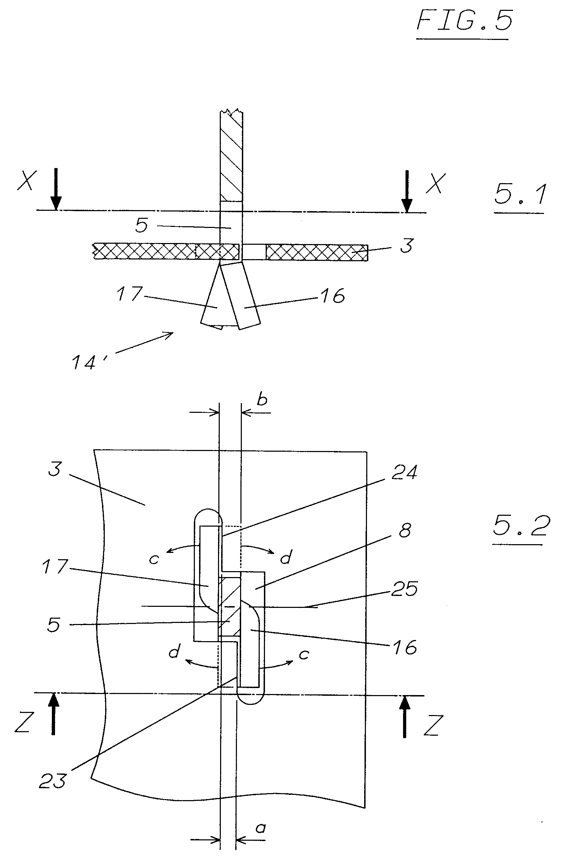

In der Fig. 5 ist das in der Leiterplatte 3 steckende und verrastete Befestigungselement 14 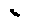 zu sehen. 5.1 zeigt dabei einen Schnitt entlang der Linie Z-Z aus 5.2, während 5.2 einen Schnitt entlang X-X aus 5.1 darstellt. Die vergrößerte Darstellung zeigt an, daß sich die beiden Flügel 16, 17 zunächst beim Einstecken des Befestigungselements 14 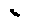 in die Öffnung 8 in Pfeilrichtung C verdrehen, während nach dem erfolgtem Einstecken eine Bewegung in Pfeilrichtung d stattfindet. Das Befestigungselement 14 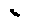 ist damit in der Leiterplatte 3 verrastet. Zur Sicherheit der Rastung steht der Abstand der beiden Konturkanten 23, 24 (Maß a) in einem bestimmten Verhältnis zur Dicke des Befestigungselements 14 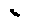 (Maß b). Dieses Verhältnis ist abhängig von der Dicke des Befestigungselements 14 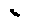 .

## Patentansprüche

1. Einrichtung (1) zum Befestigen eines LC-Displays (4) auf einer Leiterplatte (3), bestehend aus dem LC-Display (4), der Leiterplatte (3), einem Rahmen (9) mit inliegenden Leitgummistreifen (11), einem Gehäuse (2), und mehreren an der Schnittkante (22) des Gehäuses (2) angeordneten Befestigungselementen (14) zur Rastverbindung des LC-Displays (4) mit der Leiterplatte (3),
**dadurch gekennzeichnet,** daß das Befestigungselement (14 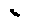 ) in Form einer Drehfeder-Rastverbindung ausgestaltet ist, mit einem Dreh-Federbereich (5) und mit zwei mit diesem verbundenen Flügeln (16,17), deren Flächen, bezogen auf die Seitenfläche des Gehäuses (2), nach unten schräg verlaufen und welche beim Befestigen um eine Drehachse (25) des Dreh-Federbereichs (5) im gleichen Drehsinn gedreht werden.

2. Einrichtung (1) nach Anspruch 1,
**dadurch gekennzeichnet,** daß das Befestigungselement (14 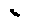 ) nur einen Flügel (16) aufweist, wodurch beim Befestigen eine Dreh-, Biegefeder-Rastverbindung erzielt wird.

3. Einrichtung (1) nach den Ansprüchen 1 und 2,
**dadurch gekennzeichnet,** daß das Gehäuse (2) sowohl an seinen Längs- wie auch an seinen Querseiten Befestigungselemente (14 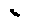 ) aufweist.

4. Einrichtung (1) nach den Ansprüchen 1 bis 3,
**dadurch gekennzeichnet,** daß der unterhalb der Leiterplatte (3) herausragende Teil des Befestigungselementes (14 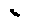 ) nur minimal ist.

5. Einrichtung nach den Ansprüchen 1 bis 4,
**dadurch gekennzeichnet,** daß der Abstand der beiden Konturkanten (23,24,) der Öffnung (8) (Maß a) zur Dicke des Befestigungselements (14 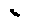 ) (Maß b) in einem bestimmten, von der Dicke des Befestigungselements (14 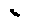 ) abhängigen Verhältnis steht, damit eine sichere Rastung des Befestigungselements (14 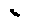 ) in der Leiterplatte (3) gewährleistet ist.

6. Einrichtung nach einem der bisherigen Ansprüche,
**dadurch gekennzeichnet,** daß die Öffnungen (8) in der Leiterplatte (3) die Form von zwei parallel nebeneinander verlaufenden Langlöchern besitzen, die an ihren jeweils zugewandten Enden eine Verbindung aufweisen und daß die einander zugewandten parallelen Schnittkanten der Langlöcher die Konturkanten (23,24) bilden.
